(19) Europäisches Patentamt / European Patent Office / Office européen des brevets

(11) **EP 1 344 317 B1**

(12) **EUROPÄISCHE PATENTSCHRIFT**

(45) Veröffentlichungstag und Bekanntmachung des Hinweises auf die Patenterteilung:
**20.10.2010  Patentblatt 2010/42**

(21) Anmeldenummer: **01990576.9**

(22) Anmeldetag: **19.12.2001**

(51) Int Cl.:
*H03K 17/0814* *(2006.01)*

(86) Internationale Anmeldenummer:
**PCT/EP2001/015042**

(87) Internationale Veröffentlichungsnummer:
**WO 2002/051010 (27.06.2002 Gazette 2002/26)**

(54) **ANSTEUERSCHALTUNG**

CONTROL CIRCUIT

CIRCUIT DE COMMANDE

(84) Benannte Vertragsstaaten:
**AT BE CH CY DE DK ES FI FR GB GR IE IT LI LU MC NL PT SE TR**

(30) Priorität: **20.12.2000  DE 10065194**

(43) Veröffentlichungstag der Anmeldung:
**17.09.2003  Patentblatt 2003/38**

(73) Patentinhaber: **Flextronics International Kft.
Tab 8660 (HU)**

(72) Erfinder:
 • **RODER, Matthias
   72766 Reutlingen (DE)**
 • **FLOCK, Horst
   72766 Reutlingen (DE)**

(74) Vertreter: **Rupprecht, Kay et al
Meissner, Bolte & Partner GbR
Widenmayerstraße 48
80538 München (DE)**

(56) Entgegenhaltungen:
**EP-A- 1 028 527**

**Beschreibung**

Die Erfindung betrifft eine Steuerschaltung für mindestens eine induktive Last, umfassend zwischen einem ersten Spannungsanschluss und einem zweiten Spannungsanschluss liegenden erste und zweite Lastzweige, von denen jeder einen elektronischen Schalter und die induktive Last in Reihe geschaltet umfasst, wobei der elektronische Schalter zwischen einem ersten Anschluss der induktiven Last und dem ersten Spannungsanschluss liegt und ein zweiter Anschluss der induktiven Last mit dem zweiten Spannungsanschluss in Verbindung steht, einen Freilaufzweig, welcher als Reihenschaltung eine mit dem ersten Spannungsanschluss verbundene Kapazität und eine mit dem zweiten Anschluss der induktiven Last verbundene Induktivität sowie jeweils eine zwischen einem Mittelabgriff zwischen der Kapazität und der Induktivität des Freilaufzweigs und dem ersten Anschluss der jeweiligen induktiven Last liegende Freilaufdiode aufweist, über welche beim geöffneten elektronischen Schalter ein Freilaufstrom der induktiven Last fließt.

Eine derartige Steuerschaltung ist aus dem Stand der Technik, beispielsweise der DE 197 02 949 A1 bzw. EP-A2-1 028 527 bekannt.

Bei derartigen Freilaufschaltungen besteht das Problem, daß der Versorgungsstrom aufgrund des Abschaltens des elektronischen Schalters erheblichen Schwankungen unterliegt und daß außerdem trotz geeigneter Ansteuerung des elektronischen Schalters Spannungsspitzen auftreten.

Der Erfindung liegt daher die Aufgabe zugrunde, eine Steuerschaltung der gattungsgemäßen Art derart zu verbessern, daß an den Spannungsanschlüssen möglichst geringe Schwankungen des Versorgungsstroms und möglichst geringe Spannungsspitzen auftreten.

Diese Aufgabe wird bei einer Steuerschaltung der eingangs beschriebenen Art erfindungsgemäß dadurch gelöst, daß die induktive Last im ersten Lastzweig ein erster Motor und die induktive Last im zweiten Lastzweig ein zweiter Motor ist, und dass der Einschaltzeitpunkt eines der elektronischen Schalter und der Ausschaltzeitpunkt des anderen der elektronischen Schalter relativ zueinander festgelegt sind und dass der Zeitraum zwischen dem Einschaltzeitpunkt des einen der elektronischen Schalter und der Einschaltzeitpunkt des anderen der elektronischen Schalter entsprechend dem Wert des einzustellenden PWM-Verhältnisses variiert.

Diese Lösung erlaubt es, die elektronischen Schalter mit PWM-Signalen derselben Periodendauer phasenstarr zu betreiben und gleichzeitig noch das PWM-Verhältnis zu variieren.

Der Vorteil der erfindungsgemäßen Lösung ist darin zu sehen, daß beim Übergang vom bestromten Zustand in den Freilaufzustand von der Kapazität und der Induktivität des Freilaufzweigs Schwankungen des zu den Spannungsanschlüssen fließenden Versorgungsstroms reduziert werden und außerdem an dem elektronischen Schalter und am Mittelabgriff des Freilaufzweigs auftretende Spannungsspitzen ausgeglichen werden und sich nicht oder nur unwesentlich auf den ersten Spannungsanschluß und den zweiten Spannungsanschluß auswirken und somit der erste Spannungsanschluß und der zweite Spannungsanschluß gegen unerwünschte Spannungsspitzen abgeschirmt werden.

Durch ein Parallelschalten eines zweiten Lastzweigs lassen sich mit ein und demselben Freilaufzweig die erfindungsgemäßen Vorteile bei zwei oder auch mehr Lastzweigen erreichen, so daß eine Ersparnis hinsichtlich des Schaltungsaufwands erzielbar ist.

Dabei ist es nicht notwendig, daß die elektrischen Größen der Bauelemente des zweiten Lastzweigs mit denen des ersten Lastzweigs identisch sind. Vielmehr ist es problemlos möglich, in den Lastzweigen mit Bauelementen zu arbeiten, die unterschiedliche elektrische Größen aufweisen, beispielsweise mit unterschiedlichen induktiven Lasten.

Um die unerwünschten Spannungsspitzen am Mittelabgriff des jeweiligen Lastzweigs möglichst klein zu halten, ist vorzugsweise vorgesehen, daß ein erster Anschluß der Kapazität des Freilaufzweigs mit einem ersten Anschluß des elektronischen Schalters mittels einer Leitung verbunden ist, deren Induktivität kleiner als 50 Nano Henry ist. Mit einer derart niederinduktiven Verbindung läßt sich eine möglichst rasche Stromänderung des Stroms durch den Kondensator erreichen.

Ferner ist es günstig, um die Spannungsspitzen klein zu halten, wenn ein zweiter Anschluß der Kapazität des Freilaufzweigs mit der jeweiligen Diode mit einer Leitung verbunden ist, deren Induktivität kleiner als 50 Nano Henry ist, so daß auch in dieser Leitung eine möglichst rasche Änderung des Stroms erfolgen kann.

Hinsichtlich der Ansteuerung der elektronischen Schalter für zwei Lastzweige wurden bislang keine näheren Angaben gemacht. So sieht ein vorteilhaftes Ausführungsbeispiel vor, daß eine Ansteuerung für die elektronischen Schalter der mindestens zwei Lastzweige vorgesehen ist, welche die elektronischen Schalter mit pulsweitenmodulierten Ansteuersignalen oder PWM-Ansteuersignalen derselben Periodendauer ansteuert, so daß hinsichtlich der Erzeugung der PWM-Ansteuersignale schaltungstechnische Vereinfachungen möglich sind.

Um jedoch die PWM-Ansteuersignale für beide Lastzweige synchronisieren zu können, ist vorzugsweise vorgesehen, daß die PWM-Ansteuersignale für beide Lastzweige phasenstarr zueinander sind.

Noch vorteilhafter ist es, wenn die PWM-Ansteuersignale zueinander phasenverschoben sind, so daß die Möglichkeit besteht, den Freilaufzweig dadurch mit einer möglichst geringen Belastung zu betreiben, daß versucht wird, einen bestromten Zustand in einem Lastzweig einem Freilaufzustand im anderen Lastzweig zuzuordnen.

Besonders günstig ist es dabei, wenn eine Ansteuerung die elektronischen Schalter im ersten und zweiten

Lastzweig so angesteuert, daß einer der elektronischen Schalter dann eingeschaltet wird, wenn der andere der elektronische Schalter ausgeschaltet ist. Dadurch ist zumindest für einen Teil der Periodendauer ein Zustand erreichbar, bei welchem zumindest kurzzeitig ein Lastzweig im Freilaufzustand und der andere im bestromten Zustand ist.

Besonders vorteilhaft ist es, wenn in einem ersten Betriebsbereich ein Einschalten jedes der elektronischen Schalter nur dann erfolgt, wenn der jeweils andere elektronische Schalter ausgeschaltet ist.

Diese Betriebsweise erlaubt es, den Freilaufzweig in einem ersten Betriebsbereich möglichst gering zu belasten, da stets sichergestellt ist, daß einer der Lastzweige im Freilaufzustand ist, solange der andere der Lastzweige im bestromten Zustand ist.

Vorteilhaft läßt sich dies dann realisieren, wenn in dem ersten Betriebsbereich das Ausschalten jedes der elektronischen Schalter mit einem zeitlichen Zwischenraum vor einem Einschalten des jeweils anderen elektronischen Schalters erfolgt.

Eine vorteilhafte Lösung sieht dabei vor, daß in dem ersten Betriebsbereich zwischen dem Ausschalten jedes der elektronischen Schalter und dem Einschalten des jeweils anderen elektronischen Schalters eine Mindestzeitdauer von beispielsweise 0,5 % der Periodendauer vorgesehen ist, so daß der ausschaltende elektronische Schalter sicher ausgeschaltet ist.

Ferner lassen sich in dem ersten Betriebsbereich trotz phasenstarrem Betreiben der elektronischen Schalter die PWM-Ansteuersignale dadurch variieren, daß in dem ersten Betriebsbereich der Einschaltzeitpunkt des einen elektronischen Schalters und der Ausschaltzeitpunkt des anderen elektronischen Schalters relativ zum Ausschaltzeitpunkt des einen elektronischen Schalters und zum Einschaltzeitpunkt des anderen elektronischen Schalters variieren.

Ein Betreiben der elektronischen Schalter im ersten Betriebsbereich ist jedoch nur bis zum Erreichen eines PWM-Verhältnisses von ungefähr 50 % möglich.

Bei einem PWM-Verhältnis von mehr als 50 % lassen sich die vorstehend erläuterten Bedingungen nicht realisieren.

Aus diesem Grund ist vorzugsweise vorgesehen, daß in einem zweiten Betriebsbereich ein Einschalten eines der elektronischen Schalter nur beim Ausschalten oder nach dem Ausschalten des anderen der elektronischen Schalter erfolgt. Diese Vorgehensweise ermöglicht es, zumindest teilweise noch das Ausschalten des einen elektronischen Schalters und das Einschalten des anderen elektronischen Schalters ungefähr gleichzeitig oder zumindest zeitnah durchzuführen.

Besonders geeignet ist diese Lösung dann, wenn von dem ersten Betriebszustand in einen zweiten Betriebszustand übergegangen wird und PWM-Verhältnisse von mehr als 50 % im zweiten Betriebszustand zur Steuerung der elektronischen Schalter eingesetzt werden.

Eine andere Möglichkeit sieht vor, daß in dem zweiten Betriebsbereich ein Einschalten jedes der elektronischen Schalter nach dem Einschalten und vor dem Ausschalten des jeweils anderen der elektronischen Schalter erfolgt.

Im Zusammenhang mit der bisherigen Erläuterung der erfindungsgemäßen Lösung wurde nicht auf die Dimensionierung des Freilaufzweigs eingegangen.

So sieht ein besonders vorteilhaftes Ausführungsbeispiel vor, daß das Produkt aus dem Wert der Induktivität und dem Wert der Kapazität im Freilaufzweig größer ist als das Quadrat der Zykluszeit der pulsweitenmodulierten Ansteuersignale.

Mit dieser Dimensionierung wird erreicht, daß sich Stromänderungen und Spannungsspitzen beim Ausschalten und Einschalten der elektronischen Schalter nur in dem gewünschten geringen Maße auf den Speisespannungsanschluß und den Masseanschluß auswirken.

Um eine möglichst gute Unterdrückung von Stromänderungen und Spannungsspitzen zu erreichen, ist vorzugsweise vorgesehen, daß der Wert der Kapazität des Freilaufzweigs größer ist als das Produkt aus dem Maximalwert des Stroms durch die induktive Last oder die induktiven Lasten mit der Zykluszeit, dividiert durch die Spannung zwischen dem ersten Spannungsanschluß und dem zweiten Spannungsanschluß.

Bei einer Dimensionierung ist dabei zu beachten, daß als Strom durch die induktive Last bei mehreren Lastzweigen stets der größere Wert von den jeweils maximal möglichen Strömen durch die Lastzweige zu berücksichtigen ist.

Die erfindungsgemäße Lösung arbeitet in allen Fällen, in welchen einer der Spannungsanschlüsse mit dem Speisespannungsanschluß verbunden ist und der andere der Spannungsanschlüsse mit dem Masseanschluß.

Besonders günstig ist es jedoch, insbesondere für die Anwendung der erfindungsgemäßen Lösung in einem Kraftfahrzeug, wenn der erste Spannungsanschluß mit dem Speisespannungsanschluß verbunden ist und der zweite Spannungsanschluß mit dem Masseanschluß.

Weitere Merkmale und Vorteile der Erfindung sind Gegenstand der nachfolgenden Beschreibung sowie der zeichnerischen Darstellung einiger Ausführungsbeispiele. In der Zeichnung zeigen:

Fig. 1    ein Schaltdiagramm einer Steuerschaltung mit einem ersten Last- zweig im bestromten Zustand;

Fig. 2    ein Schaltdiagramm der Steuerschaltung von Fig. 1 im Frei- laufzustand des ersten Lastzweigs;

Fig. 3 ein Schaltdiagramm eines Ausführungsbeispiels einer erfindungsgemäßen Steuerschaltung mit einem Freilaufzweig und zwei Lastzweigen, welche beide im bestromten Zustand sind;

Fig. 4 ein Schaltdiagramm des Ausführungsbeispiels im Frei- laufzustand beider Lastzweige;

Fig. 5 ein Schaltdiagramm des Ausführungsbeispiels im Frei- laufzustand des zweiten Lastzweigs und im bestromten Zustand des ersten Lastzweigs;

Fig. 6 eine Darstellung von Meßwerten beim Ausführungs- beispiel bei einem Pulsweitenmodulationsverhältnis von 30 %;

Fig. 7 eine Darstellung von Meßwerten beim Ausführungs- beispiel bei einem Pulsweitenmodulationsverhältnis von 50 % und

Fig. 8 eine Darstellung von Meßwerten des Ausführungs- beispiels bei einem Pulsweitenmodulationsverhältnis von 80 %.

Ein erstes Ausführungsbeispiel einer Ansteuerschaltung 10, beispielsweise für einen eine induktive Last darstellenden Motor M1, mit welchem z. B. in einem Kraftfahrzeug ein Lüfterrad angetrieben wird, umfaßt eine Spannungsquelle V, welche zwischen einem Speisespannungsanschluß 12 und einem Masseanschluß 14 der Ansteuerschaltung 10 liegt und eine Speisespannung U erzeugt.

Ferner umfaßt die Ansteuerschaltung 10 einen ersten Lastzweig 20, in welchem ein elektronischer Schalter S1 und die induktive Last, in diesem Fall der Motor M1, in Reihe geschaltet sind, wobei der elektronische Schalter S1 zwischen einem ersten Anschluß 22 der induktiven Last und dem Speisespannunsanschluß 12 liegt und dabei mit einem ersten Anschluß ES1 mit dem Speisespannungsanschluß 12 verbunden ist und ein zweiter Anschluß 24 der induktiven Last M1 mit dem Masseanschluß 14 verbunden ist.

Ferner ist der erste Anschluß 22 der induktiven Last mit einem Mittelabgriff 26 des ersten Lastzweigs 20 verbunden.

Darüber hinaus umfaßt die Ansteuerschaltung einen Freilaufzweig 30, in welchem eine Kapazität C und eine Induktivität L in Reihe geschaltet sind, wobei ein erster Anschluß 32 der Kapazität C mit dem Speisespannungsanschluß 12 verbunden ist und ein zweiter Anschluß 34 der Kapazität C mit einem Mittelabgriff 36 des Freilaufzweigs 30 verbunden ist, der seinerseits wiederum mit einem ersten Anschluß 38 der Induktivität L verbunden ist, die über einen zweiten Anschluß 40 mit dem Masseanschluß 14 verbunden ist.

Ferner liegt zwischen dem Mittelabgriff 36 des Freilaufzweigs 30 und dem Mittelabgriff 26 des ersten Lastzweigs 20 eine Freilaufdiode D1 des Freilaufzweigs 30 deren Durchlaßrichtung so gewählt ist, daß sie einen Strom vom Mittelabgriff 36 zum Mittelabgriff 26 fließen läßt, jedoch in umgekehrter Richtung sperrt.

Der elektronische Schalter S1 ist ferner mittels eines ersten pulsweitenmodulierten Ansteuersignals S1A ansteuerbar, welches von einer Motorsteuerschaltung 42 entsprechend der geforderten Leistung des Motors M1 und mit einer feststehenden Zykluszeit TZ erzeugt wird.

Diese Ansteuerschaltung arbeitet dabei folgendermaßen:

Ist der elektronische Schalter S1 durch das pulsweitenmodulierte Ansteuersignal S1A geschlossen, so fließt zum Betrieb des Motors M1 während einer Beströmungszeit TS ein gestrichelt mit Pfeilen gekennzeichneter Strom IM1 vom Speisespannungsanschluß 12 über den ersten elektronischen Schalter S1, dem Mittelabgriff 26 und den Motor M1 zum Masseanschluß 14.

Der Strom IM1 durch den Motor M1 ist dabei die Summe der sich am Speisespannungsanschluß 12 vereinigenden Teilströme IV und IC1E, wobei die Spannungsquelle V den Teilstrom IV liefert und der Teilstrom IC1E durch Entladen des Kondensators C von dessen erstem Anschluß 32 in Richtung des Speisespannungsanschlusses 12 abfließt.

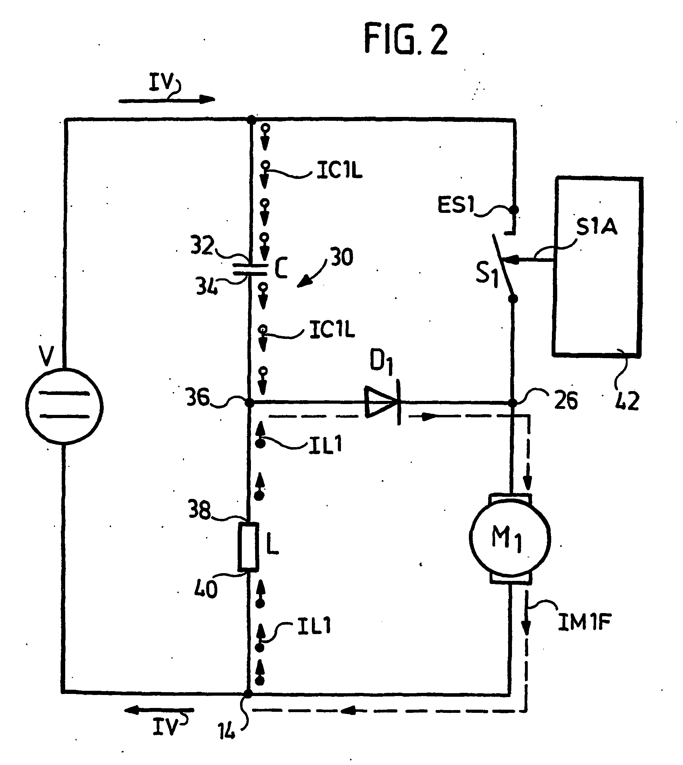

Ferner fließt von dem Masseanschluß 14 ein Strom IL1 durch die Induktivität L und zwar in Richtung des Mittelabgriffs 36 und vom Mittelabgriff 36 als Strom IC1E zum zweiten Anschluß 34 des Kondensators C, so daß sich an dem Masseanschluß 14 der Strom IM1 aufteilt, wobei der Teilstrom IV zur Spannungsquelle V fließt, während der Teilstrom IL1 durch die Induktivität L zum Kondensator C fließt, wobei IC1E und IL1 in diesem Fall gleich groß sind. Wird dagegen, wie in Fig. 2 dargestellt, der Schalter S1 durch das Ansteuersignal S1A geöffnet, so fließt vom Speisespannungsanschluß 12 über den elektronischen Schalter S1 kein Strom mehr und der Motor M1 wird für die Dauer einer Freilaufzeit TF im Freilaufzustand betrieben. Während dieser Zeit fließt vom Speisespannungsanschluß 12 ein entgegengesetzt zum Strom IC1E fließender Strom IC1L zum ersten Anschluß 32 des Kondensators C und lädt diesen auf, wobei der Strom IC1L dem Strom IV entspricht, welcher von der Spannungsquelle V zum Speisespannungsanschluß 12 fließt. Dabei ist der Strom IV während der Beströmungsperiode TS und der Freilaufperiode näherungsweise gleich groß.

Ferner fließt vom zweiten Anschluß 34 des Kondensators C der Strom IC1L zum Mittelabgriff 36.

Im Freilaufzustand fließt vom Mittelabgriff 36 ein Strom IM1F über die Diode 1 zum Mittelabgriff 26 des ersten Lastzweigs 20 und von diesem über den Motor M1 zum Masseanschluß 14.

Dieser Strom IM1F wird gebildet durch zwei Teilströme, nämlich als ersten Teilstrom den Strom IC1L, welcher durch Aufladen des Kondensators C entsteht und andererseits durch den Strom IL1, der nach wie vor durch die Induktivität L zum Mittelabgriff 36 des Freilaufzweigs 30 fließt.

Ferner teilt sich der Strom IM1 am Masseanschluß 14 wiederum auf in den Strom IL1, der zum zweiten Anschluß 40 der Induktivität L und durch diese hindurchfließt, sowie einem Strom IV, welcher zur Spannungsquelle V zurückfließt.

In diesem Zustand ist der Strom IV gleich dem Strom IC1L, wobei der Strom IC1L theoretisch so lange fließen würde, bis der Kondensator C aufgeladen ist.

Die vorteilhaften Wirkungen des Freilaufzweigs 30 lassen sich bei folgenden Dimensionierungen der Kapazität C und der Induktivität L erreichen.

$$(1) \quad L \bullet C \quad \gg \quad (TZ)^2$$

$$(2) \quad C > (\text{Maximalwert IM1}) \bullet \frac{TZ}{U}$$

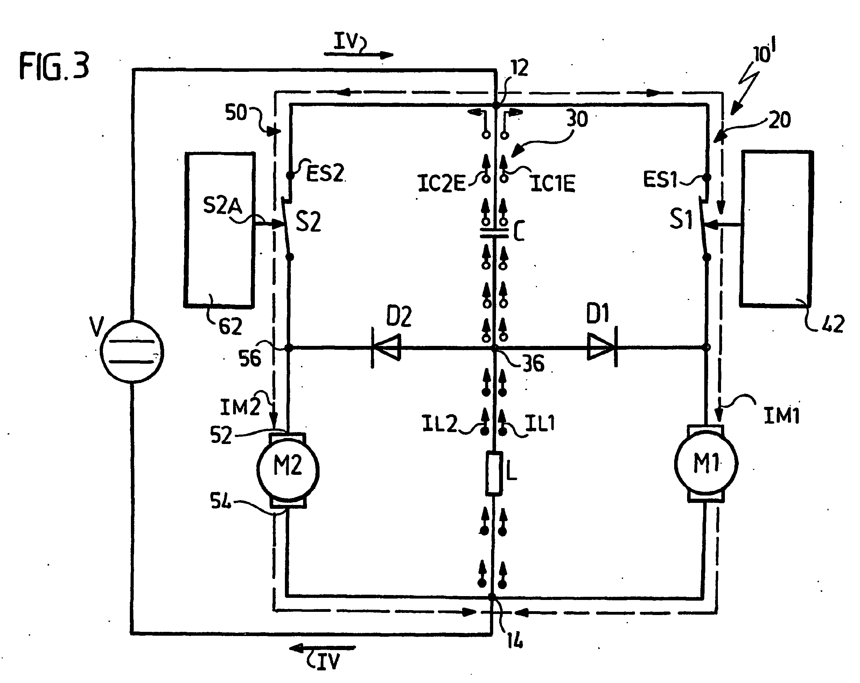

Bei einem Ausführungsbeispiel einer erfindungsgemäßen Ansteuerschaltung 10', dargestellt in den Fig. 3 bis 5 ist zwischen dem Speisespannungsanschluß 12 und dem Masseanschluß 14 nicht nur der erste Lastzweig 20 vorgesehen, sondern ein zweiter Lastzweig 50, welcher ähnlich dem ersten Lastzweig 20 ausgebildet ist. Der zweite Lastzweig 50 umfaßt daher ebenfalls einen elektronischen Schalter S2, welcher mit einer induktiven Last, nämlich einem zweiten Motor M2, in Reihe geschaltet ist, wobei der elektronische Schalter S2 zwischen dem Speisespannungsanschluß 12 und einem ersten Anschluß 52 des zweiten Motors M2 liegt und dabei mit einem ersten Anschluß ES1 mit dem Speisespannungsanschluß 12 verbunden ist und ein zweiter Anschluß 54 des zweiten Motors M2 mit dem Masseanschluß 14 verbunden ist.

Ferner ist der zweite Lastzweig 50 mit einem Mittelabgriff 56 versehen, wobei zwischen dem Mittelabgriff 56 und dem Mittelabgriff 36 des Freilaufzweigs 30' eine Diode D2 vorgesehen ist, um welche der Freilaufzweig 30' ergänzt ist, wobei die Diode D2 mit ihrer Durchlaßrichtung so geschaltet ist, daß sie einen Strom vom Mittelabgriff 36 zum Mittelabgriff 56 zuläßt, jedoch in umgekehrter Richtung sperrt.

Ferner ist der elektronische Schalter S2 durch eine zweite Motorsteuerschaltung 62 mittels eines pulsweitenmodulierten Ansteuersignals S2A ansteuerbar, wobei das Ansteuersignal S2A vorzugsweise dieselbe Zykluszeit TZ aufweist, wie das Ansteuersignal S1A.

Für die Dimensionierung der Kapazität C gilt beim zweiten Ausführungsbeispiel

$$C > (\text{Maximalwert IM1, IM2}) \ \frac{TZ}{U}$$

wobei für den (Maximalwert IM1, IM2) der Wert einzusetzen ist, der dem größten maximalen Strom durch die induktive Last in den Lastzweigen 20, 50 entspricht.

Sind nun bei dem Ausführungsbeispiel der erfindungsgemäßen Ansteuerschaltung 10' die beiden Schalter S1 und S2 geschlossen, so fließt analog zum ersten Ausführungsbeispiel über den ersten Motor M1 der Strom IM1 und über den Motor M2 der Strom IM2, wobei die Ströme IM1 und IM2 jeweils aus zwei Teilströmen gebildet werden, von denen einer durch den von der Spannungsquelle V gelieferten Strom IV geliefert wird und der andere Teilstrom durch die Ströme IC1E bzw. IC2E, die beim Entladen der Kapazität C entstehen, wobei der Teilstrom IC1E zum Strom IM1 durch den ersten Motor M1 und der Teilstrom IC2E zum Strom IM2 durch den zweiten Motor M2 beitragen.

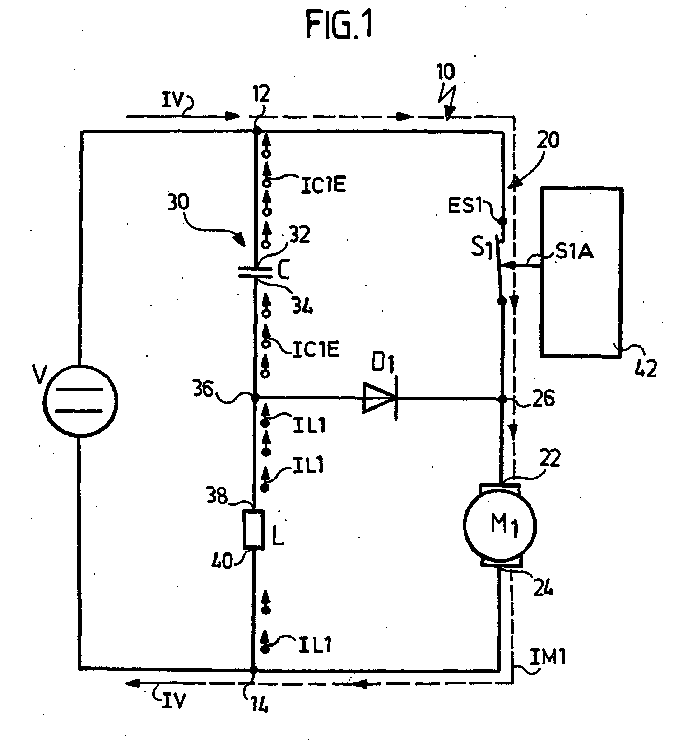

Ferner fließen entsprechend dem in Fig. 1 dargestellten Fall des ersten Ausführungsbeispiels auch beim in Fig. 3 dargestellten Ausführungsbeispiel die Ströme IL1 und IL2 durch die Induktivität L, wobei die Ströme IL1 und IL2 den Strömen IC1E und IC2E entsprechen.

Ferner teilen sich die Ströme IM1 und IM2 am Masseanschluß 14 wiederum in die Teilströme IL1 bzw. IL2 sowie weitere Teilströme, die den zur Spannungsquelle V fließenden Strom IV ergeben.

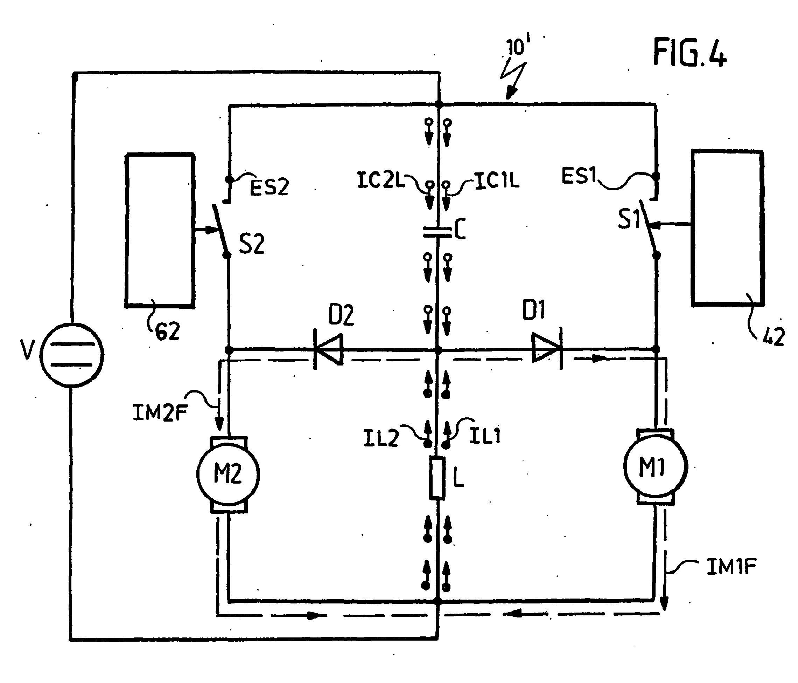

Sind, wie in Fig. 4 dargestellt, beide Schalter S1 und S2 ausgeschaltet, so ergeben sich Verhältnisse, die denen des ersten Ausführungsbeispiels, dargestellt in Fig. 2 entsprechen. Das heißt, daß jeweils durch die Motoren M1 und M2 die Freilaufströme IM1F und IM2F, die jeweils wieder die Summe aus den Strömen IC1L bzw. IC2L sowie IL1 und IL2 darstellen, analog dem Freilaufzustand des ersten Ausführungsbeispiels, dargestellt und beschrieben in Fig. 2.

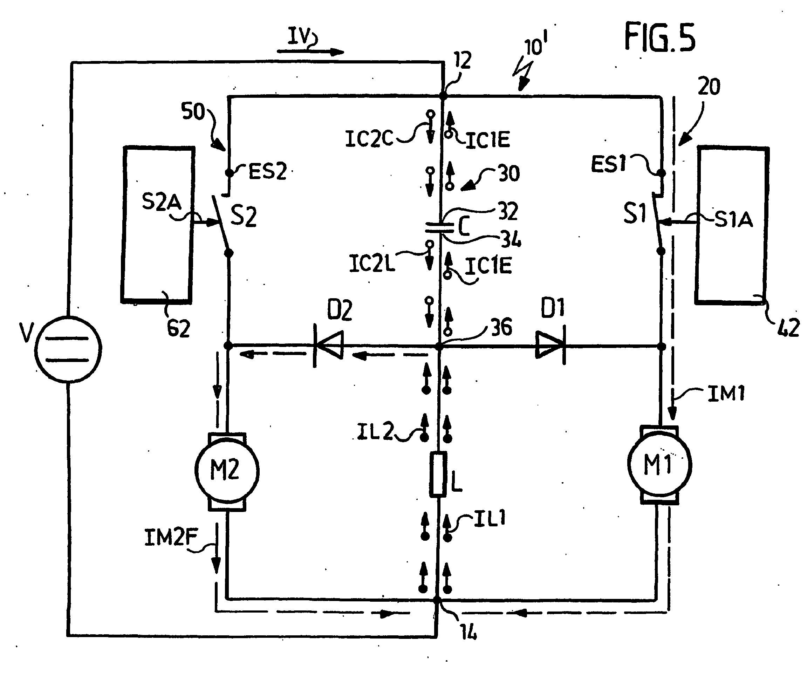

Das Ausführungsbeispiel der erfindungsgemäßen Ansteuerschaltung 10' kann jedoch, wie in Fig. 5 dargestellt in einem weiteren Zustand betrieben werden, nämlich in einem Zustand, in welchem beispielsweise der elektronische Schalter S1 geschlossen und der elektronische Schalter S2 geöffnet ist.

In diesem Fall fließt im ersten Lastzweig 20 analog dem in Fig. 1 und 3 dargestellten Fall der Strom IM1 durch den Motor M1, während im zweiten Lastzweig 50 aufgrund des geöffneten Schalters S2 der Freilaufzustand vorliegt, so daß in diesem der Strom IM2F fließt.

Dies führt im Freilaufzweig 30 dazu, daß entsprechend dem Zustand des ersten Lastzweiges 20 von dem ersten Anschluß 32 der Kapazität C der Strom IC1E zum Speisespannungsanschluß 12 fließt, um als Teilstrom mit einem weiteren Teilstrom des Stroms IV den Strom IM1 zu bilden, wobei aufgrund des Stroms IM1 durch den ersten Lastzweig 20 auch durch die Induktivität der Strom IL1 fließt.

Andererseits ist der zweite Lastzweig 50 im Freilaufzustand, was bedeutet, daß von dem zweiten Anschluß 34 des Kondensators C ein Strom IC2L zum Mittelabgriff 36 fließt und außerdem vom Speisespannungsanschluß 12 ein Strom IC2L zum ersten Anschluß 34 der Kapazität C fließt, wobei durch den Strom IC2L ein Laden der Kapazität C erfolgt.

Ferner führt der Freilaufzustand im zweiten Lastzweig 50 dazu, daß durch die Induktivität L der Strom IL2 von dem Basisanschluß 14 zum Mittelabgriff 36 führt und zusammen mit dem Strom IC2L sich zum Strom IM2F addiert, welcher durch den zweiten Motor M2 fließt.

Wie ein Vergleich der Richtungen der Ströme IC1E und IC2L zeigt, fließen diese gegensinnig, so daß diese sich zumindest teilweise aufheben, so daß je nach dem, ob der Strom IC1E oder der Strom IC2L überwiegt, ein resultierender Strom entweder den Kondensator C entlädt oder auflädt, wobei dieser resultierende Strom kleiner ist als die Beträge der Ströme IC1E und IC2L.

Darüber hinaus ist bei dem Schaltzustand des Ausführungsbeispiels gemäß Fig. 5 deutlich zu erkennen, daß die Ströme IL1 und IL2, wie sich auch aus den Schaltzuständen gemäß Fig. 3 und Fig. 4 ergibt, zumindest ihre Richtung beibehalten und nur betragsmäßig schwanken können, während sich beim Vergleich der Ströme IC1E oder IC2E und IC1L oder IC2L zeigt, daß diese abhängig davon, welcher der Motoren M1 und/oder M2 im Freilaufzustand ist, ihre Richtung ändern, wobei sie in dem Fall, in dem einer der Motoren, nämlich der Motor M1, im bestromten Zustand ist und der andere der Motoren, nämlich der Motor M2, im Freilaufzustand ist, sich die Ströme IC1E und IC2L zumindest teilweise aufheben, so daß in Summe lediglich ein geringer Entlade- oder Ladestrom der Kapazität fließt.

Darüber hinaus stellt der Freilaufzweig 30 sicher, daß der von der Spannungsquelle V fließende Strom IV unabhängig von der Stellung der elektronischen Schalter S1 oder S2 im wesentlichen nicht unterbrochen wird und somit stets weiterfließt und höchstens betragsmäßig schwankt.

Da dann, wenn gemäß Fig. 5 einer der Motoren, beispielsweise der erste Motor M1, im bestromten Zustand ist und der andere der Motoren, beispielsweise der zweite Motor M2, im nicht bestromten Zustand ist, die Ströme IC1E und IC2L sich zumindest teilweise aufheben, ist die Belastung des Freilaufzweigs 30 dann minimal, wenn während möglichst langer Perioden innerhalb der Zykluszeit TZ das Auftreten eines derartigen Zustandes angestrebt wird.

Vorzugsweise sind die Motorsteuerschaltungen 42 und 62 so betrieben, daß deren Zykluszeit TZ identisch ist.

Ferner ist vorzugsweise vorgesehen, daß die pulsweitenmodulierten Ansteuersignale S1A und S2A nicht nur die selben Zykluszeiten TZ aufweisen, sondern auch phasenstarr zueinander sind, um den Zustand, daß einer der Motoren M1, M2, beispielsweise der erste Motor M1, im bestromten Zustand ist, während der andere der Motoren M2, M1, beispielsweise der zweite Motor M2, im Freilaufzustand ist. Aus diesem Grund wird bei einem pulsweitenmodulierten Ansteuersignal S1A das pulsweitenmodulierte Ansteuersignal S2A phasenstarr angeordnet und zwar so, daß dessen der Bestromungszeit TS entsprechender Einschaltzeitraum TE1 in einen der Freilaufzeit TF entsprechenden Ausschaltzeitraum TA2 des Ansteuersignals S2A fällt, während andererseits ein Einschaltzeitraum TE2 so liegt, daß dieser in einen Ausschaltzeitraum TA1 des ersten pulsweitenmodulierten Ansteuersignals S1A fällt.

Die elektronischen Schalter S1 und S2 sind dabei entsprechend dem ersten Ansteuersignal S1A oder dem zweiten Ansteuersignal S2A in den Zeiträumen TE1 bzw. TE2 geschlossen und in den Zeiträumen TA1 bzw. TA2 geöffnet.

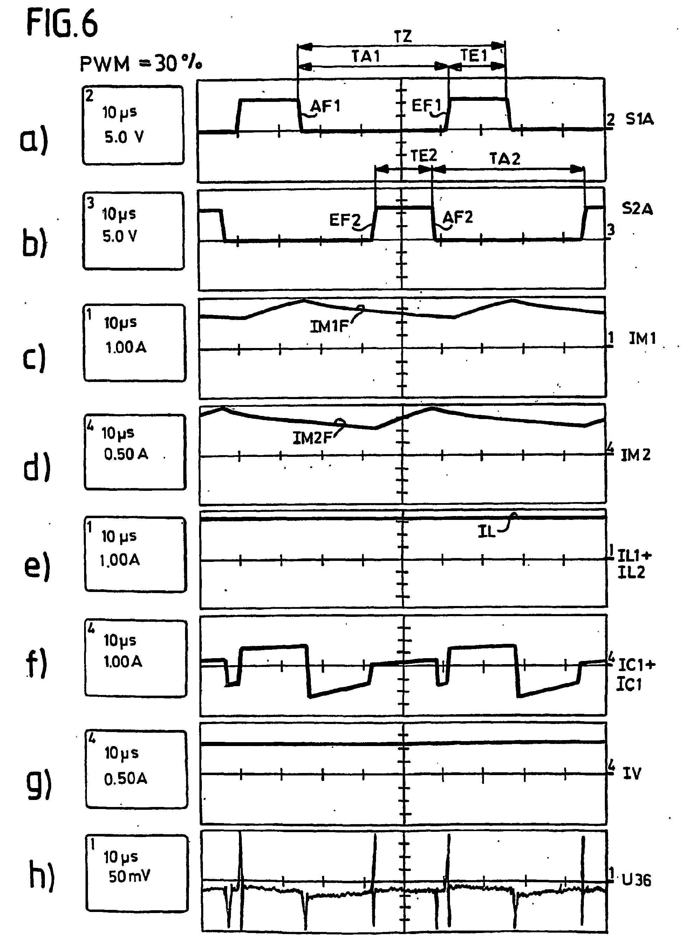

Entsprechend bilden sich die Ströme IM1 und IM2 durch die Motoren M1 und M2 aus, wie in Fig. 6c bzw. d dargestellt, wobei die unterschiedlichen Größen der Motoren M1 und M2 zu unterschiedlichen Strömen IM1 und IM2 führen.

Ferner resultiert daraus, wie in Fig. 6e dargestellt, ein Strom IL1 plus IL2, durch die Induktivität L, welche über der Zeit im wesentlichen konstant ist, während der Strom IC1 plus IC2, wie in Fig. 6f dargestellt ist, schwankt.

Schließlich zeigt Fig. 6h, daß bei dem Übergang vom Freilaufzustand zum bestromten Zustand Spannungsspitzen der Spannung U36 am Mittelabgriff 36 auftreten können. Diese Spannungsspitzen haben die Ursache in einer nicht idealen Freilauf-Kapazität, die eine nicht zu vernachlässigende Längsinduktivität besitzt, die dazu führt, daß sich der Strom durch die Kapazität C nicht schlagartig ändern kann und damit Spannungsspitzen am Mittelabgriff 36 gegenüber dem Masseanschluß 14 auftreten.

Diese Spannungsspitzen lassen sich durch eine Verbindung des ersten Anschlusses 32 der Kapazität C mit den Schaltern S1, S2 und des zweiten Anschlusses 34 mit den Dioden D1, D2 klein halten, die eine Induktivität von weniger als 50 Nano Henry aufweist.

Diese Spannungsspitzen wirken sich auch nicht auf den Speisespannungsanschluß 12 oder den Masseanschluß 14 aus, da sich diese gegenüber dem Mittelabgriff 36 durch den Kondensator C bzw. die Induktivität L abgeschirmt sind. Daher ist der Strom IV, welcher von der Spannungsquelle V zum Speisespannungsanschluß 12 und vom Masseanschluß 14 zur Spannungsquelle V fließt, im wesentlichen konstant, wie sich aus Fig. 6g ergibt.

Ferner ist in Fig. 6h beachtlich, daß die Änderung der Spannung an der Kapazität C während einer Zykluszeit TZ gering, vorzugsweise geringer als 50 mV ist, was durch eine große Kapazität C von beispielsweise

$$C > 30 \ (\text{Maximalwert IM1, IM2}) \ \frac{TZ}{U}$$

erreichbar ist.

Wird nun die Pulsweitenmodulation verändert, das heißt wird der Ausschaltzeitraum TA1 zugunsten des Einschaltzeitraums TE1 geändert, so erfolgt vorzugsweise lediglich eine Verschiebung einer Ausschaltflanke AF1 des ersten Ansteuersignals S1A, während eine Einschaltflanke EF1 nicht verschoben wird.

Dagegen wird beim zweiten Ansteuersignal S2A die Einschaltflanke EF2 verschoben, während die Ausschaltflanke AF2 unverändert stehen bleibt.

Schließlich sind das erste Ansteuersignal S1A und das zweite Ansteuersignal S2A derart synchronisiert, daß die Einschaltflanke EF1 und die Ausschaltflanke AF2 in konstanter Phasenbeziehung zueinander stehen, beispielsweise zeitlich in einem derartigen Abstand aufeinanderfolgen, daß die Abschaltflanke AF2 gerade dann den Wert Null erreicht hat, wenn die Einschaltflanke EF1 vom Wert Null zu höheren Werten abweicht.

Dadurch ist durch die Einschaltflanke EF1 und die Ausschaltflanke AF2 eine feste Phasenrelation vorgegeben, die stets sicherstellt, daß der jeweilige Einschaltzeitraum TE1 oder TE2 des einen Ansteuersignals S1A bzw. S2A dann auftritt, wenn beim anderen Ansteuersignal S2A bzw. S1A der Ausschaltzeitraum TA2 bzw. TA1 vorliegt.

Dies ist solange machbar, bis ein Pulsweitenmodulationsverhältnis von fast 50% erreicht ist, denn dann ist bei einer für das erste Ansteuersignal S1A und das zweite Ansteuersignal S2A vorgegebenen identischen Zykluszeit PZ die Möglichkeit erschöpft, daß der Einschaltzeitraum des einen Ansteuersignals S1A oder S2A mit dem Ausschaltzeitraum des anderen Ansteuersignals S2A bzw. S1A zusammenfallen.

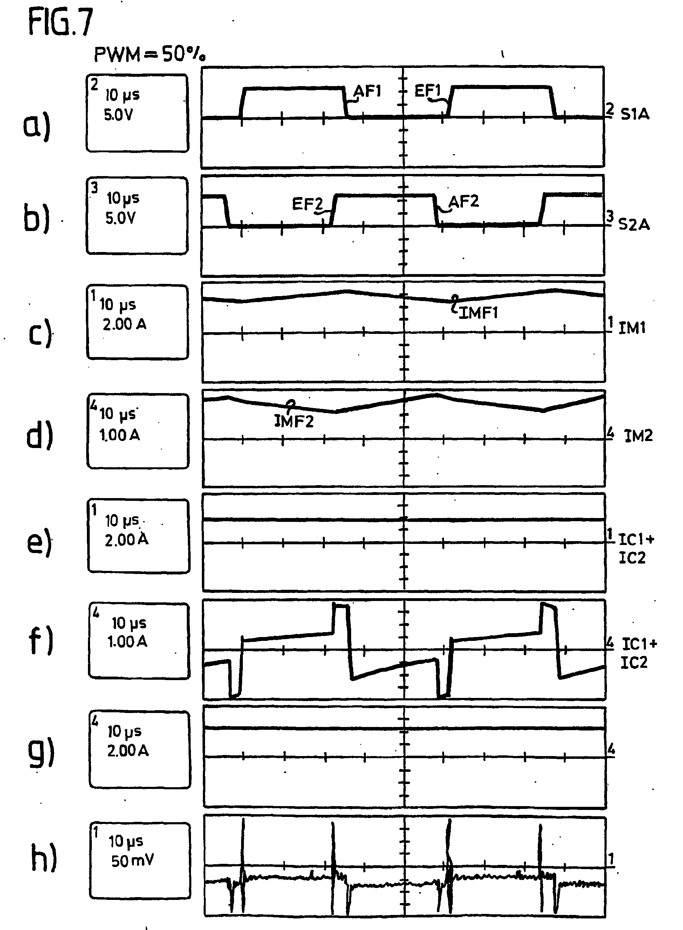

Wird dagegen ein Pulsweitenmodulationsverhältnis von näherungsweise 50% erreicht, wie beispielsweise in Fig. 7 dargestellt, so ist eine kurzzeitige Überlappung der Ansteuersignals S1A und S2A beispielsweise im Bereich der Ausschaltflanke AF1 und der Einschaltflanke EF2 nicht vermeidbar.

Damit sind für einen kurzen Zeitraum aufgrund der zeitlichen Überlappung der Einschaltflanke EF2 mit dem geschlossenen Zustand des elektronischen Schalters S1A bis zur Abschaltflanke AF1 ersten Ansteuersignals S1A ein Zustand erreicht, welcher in Fig. 3 dargestellt ist, während zwischen der Abschaltflanke AF2 und der Einschaltflanke EF1 ein Zustand vorliegt, welcher in Fig. 4 dargestellt ist, das heißt ein Zustand bei dem beide elektronischen Schalter geöffnet sind.

Dies wirkt sich in dieser Weise deutlich erkennbar in der Summe der Ströme IC1 plus IC2 aus, wie in Fig. 7f dargestellt.

Dagegen ist die Auswirkung auf die Motorströme IM1 und IM2 bei einem Vergleich mit den Verhältnissen bei einer Pulsweitenmodulation von 30% zumindest qualitativ ähnlich (Fig. 7c, 7d).

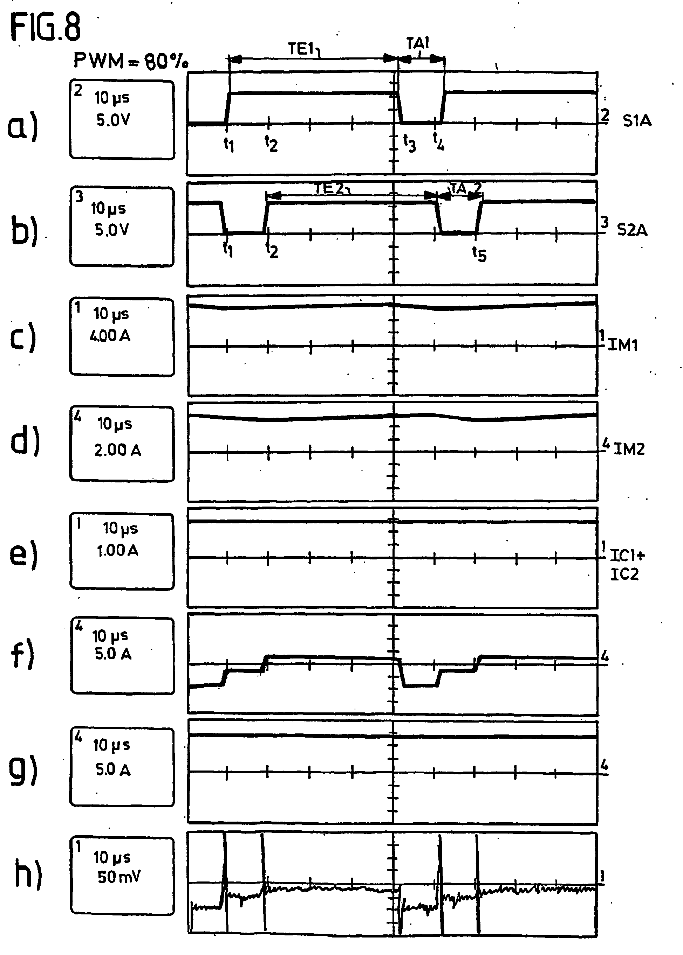

Weisen dagegen die Ansteuersignale S1A und S2A Pulsweitenmodulationsverhältnisse von ungefähr 80% auf, so überwiegt der Einschaltzeitraum TE1 und TE2 den entsprechenden Ausschaltzeitraum TA1 bzw. TA2 (Fig. 8a, 8b). In diesem Fall ist es nicht mehr möglich, daß die beiden Ansteuersignale S1A und S2A so zeitlich zueinander angeordnet sind, daß sich die Einschaltzeiträume TE1 und TE2 möglichst wenig überlagern, wobei die starre Phasenbeziehung zwischen der Ausschaltflanke AF2 des zweiten Ansteuersignals S2A zur Einschaltflanke EF1 des ersten Ansteuersignals aufrechterhalten bleibt.

Zwischen dem Zeitpunkt $t_1$ und dem Zeitpunkt $t_2$ liegen somit Verhältnisse beim Ausführungsbeispiel im Zustand gemäß Fig. 5 vor, das heißt einer der Motoren M1, M2 ist im bestromten Zustand, während der andere im Freilaufzustand ist (Fig. 8a, 8b).

Zwischen dem Zeitpunkt $t_2$ und dem Zeitpunkt $t_3$ liegen Verhältnisse gemäß Fig. 3 vor, das heißt beide Motoren sind im bestromten Zustand.

Zwischen den Zeitpunkten $t_3$ bis $t_4$ und $t_4$ bis $t_5$ liegen ebenfalls wieder der Fig. 5 entsprechende Verhältnisse vor, das heißt einer der Motoren M1, M2 ist im bestromten Zustand und der andere im Freilaufzustand.

Daraus folgt, daß sich bei dem Ausführungsbeispiel bei einer Pulsweitenmodulation von mehr als 80% im wesentlichen Schaltungszustände gemäß Fig. 3 und gemäß Fig. 5 auftreten, während Schaltungszustände gemäß Fig.

4 des Ausführungsbeispiels nicht auftreten.

Bei Pulsweitenmodulationsverhältnissen von ungefähr 80 % sind die Ströme IM1 und IM2 deutlich höher als bei den übrigen Fällen (Fig. 8c und 8d).

Darüber hinaus erreicht der Strom IL1 plus IL2 bei der Pulsweitenmodulation von 50% sein Maximum (Fig. 8e und 8f).

Bei der Summe der Ströme IC1 und ICL treten, wie in Fig. 8f dargestellt, Schwankungen auf, je nach dem, welcher der beiden unterschiedlichen Motoren M1, M2 gerade im bestromten Zustand oder im Freilaufzustand ist. Außerdem ist auch in diesem Fall der Strom IV von der Spannungsquelle V zum Speisespannungsanschluß 12 und vom Masseanschluß 14 zur Spannungsquelle V im wesentlichen konstant (Fig. 8g).

**Patentansprüche**

1. Steuerschaltung für mindestens eine induktive Last (M1, M2), umfassend zwischen einem ersten Spannungsanschluss (12) und einem zweiten Spannungsanschluss (14) liegenden erste und zweite Lastzweige (20, 50), von denen jeder einen elektronischen Schalter (S1, S2) und die induktive Last (M1, M2) in Reihe geschaltet umfasst, wobei der elektronische Schalter (S1, S2) zwischen einem ersten Anschluss (22, 52) der induktiven Last (L) und dem ersten Spannungsanschluss (12) liegt und ein zweiter Anschluss (24, 54) der induktiven Last (M1, M2) mit dem zweiten Spannungsanschluss (14) in Verbindung steht, einen Freilaufzweig (30, 30'), welcher als Reihenschaltung eine mit dem ersten Spannungsanschluss (12) verbundene Kapazität (C) und eine mit dem zweiten Anschluss (24, 54) der induktiven Last (M1, M2) verbundene Induktivität (L) sowie jeweils eine zwischen einem Mittelabgriff (36) zwischen der Kapazität (C) und der Induktivität (L) des Freilaufzweigs (30, 30') und dem ersten Anschluss (22, 52) der jeweiligen induktiven Last (M1, M2) liegende Freilaufdiode (D1, D2) aufweist, über welche beim geöffneten elektronischen Schalter (S1, S2) ein Freilaufstrom (IM1F, IM2F) der induktiven Last (M1, M2) fließt,

   **dadurch gekennzeichnet, dass** die induktive Last im ersten Lastzweig (20) ein erster Motor (M1) und die induktive Last im zweiten Lastzweig (50) ein zweiter Motor (M2) ist, dass der Einschaltzeitpunkt (EF1) eines der elektronischen Schalter (S1) und der Ausschaltzeitpunkt (AF2) des anderen der elektronischen Schalter relativ zueinander festgelegt sind und dass der Zeitraum zwischen dem Einschaltzeitpunkt (EF1) des einen der elektronischen Schalter (S1, S2) und der Einschaltzeitpunkt (EF2) des anderen der elektronischen Schalter (S2, 51) entsprechend dem Wert des einzustellenden PWM-Verhältnisses variiert.

2. Steuerschaltung nach Anspruch 1, **dadurch gekennzeichnet, dass** ein erster Anschluss (32) der Kapazität (C) des Freilaufzweigs (30) mit einem ersten Anschluss (ES1, ES2) des elektronischen Schalters (S1, S2) mittels einer Leitung verbunden ist, deren Induktivität kleiner als 50 Nano Henry ist.

3. Steuerschaltung nach einem der voranstehenden Ansprüche, **dadurch gekennzeichnet, dass** ein zweiter Anschluss (34) der Kapazität (C) des Freilaufzweigs (30) mit der jeweiligen Diode (D1, D2) mit einer Leitung verbunden ist, deren Induktivität kleiner als 50 Nano Henry ist.

4. Steuerschaltung nach einem der voranstehenden Ansprüche, **dadurch gekennzeichnet, dass** eine Ansteuerung (42, 62) für die elektronischen Schalter (51, 52) der mindestens zwei Lastzweige (20, 50) vorgesehen ist, welche die elektronischen Schalter (51, 52) mit PWM-Ansteuersignalen (S1A, S2A) derselben Periodendauer (TZ) ansteuert.

5. Steuerschaltung nach Anspruch 4, **dadurch gekennzeichnet, dass** die PWM-Ansteuersignale (S1A, S2A) für beide Lastzweige (30, 50) phasenstarr zueinander sind.

6. Steuerschaltung nach Anspruch 4 oder 5, **dadurch gekennzeichnet, dass** die PWM-Ansteuersignale (S1A, S2A) phasenverschoben zueinander sind.

7. Steuerschaltung nach einem der voranstehenden Ansprüche, **dadurch gekennzeichnet, dass** eine Ansteuerung (42, 62) die elektronischen Schalter (S1, S2) des ersten (20) und des zweiten Lastzweigs (50) so ansteuert, dass einer der elektronischen Schalter (S1) dann eingeschaltet wird, wenn der andere der elektronischen Schalter (S2) ausgeschaltet ist.

8. Steuerschaltung nach einem der voranstehenden Ansprüche, **dadurch gekennzeichnet, dass** in einem ersten Betriebsbereich ein Einschalten jedes der elektronischen Schalter (S1, S2) nur dann erfolgt, wenn der jeweils andere elektronische Schalter (S2, S1) ausgeschaltet ist.

9. Steuerschaltung nach Anspruch 8, **dadurch gekennzeichnet, dass** in dem ersten Betriebsbereich das Ausschalten jedes der Schalter (S1, S2) mit einem zeitlichen Zwischenraum vor einem Einschalten des jeweils anderen Schalters (S2, S1) erfolgt.

10. Steuerschaltung nach Anspruch 9, **dadurch gekennzeichnet, dass** in dem ersten Betriebsbereich zwischen dem Ausschalten jedes der Schalter (S1, S2) und dem Einschalten des jeweils anderen der Schalter (S2, S1) eine Mindestzeitdauer von 0,5 % der Periodendauer (TZ) vorgesehen ist.

11. Steuerschaltung nach einem der Ansprüche 8 bis 10, **dadurch gekennzeichnet, dass** in dem ersten Betriebsbereich der Einschaltzeitpunkt (EF2) des einen elektronischen Schalters (S2) und der Ausschaltzeitpunkt (AF1) des anderen elektronischen Schalters (S1) variieren.

12. Steuerschaltung nach einem der voranstehenden Ansprüche, **dadurch gekennzeichnet, dass** in einem zweiten Betriebsbereich ein Einschalten eines der elektronischen Schalter (S1, S2) nur beim Ausschalten oder nach dem Ausschalten des anderen der elektronischen Schalter (S2, S1) erfolgt.

13. Steuerschaltung nach einem der Ansprüche 1 bis 12, **dadurch gekennzeichnet, dass** in dem zweiten Betriebsbereich ein Einschalten jedes der elektronischen Schalter (S1, S2) nach dem Einschalten und vor dem Ausschalten des jeweils anderen der elektronischen Schalter (S2, S1) erfolgt.

14. Steuerschaltung nach einem der voranstehenden Ansprüche, **dadurch gekennzeichnet, dass** das Produkt aus dem Wert der Induktivität (L) und dem Wert der Kapazität (C) im Freilaufzweig (30, 30') größer ist als das Quadrat der Zykluszeit (TZ) der pulsweitenmodulierten Ansteuersignale (S1A, S2A).

15. Steuerschaltung nach einem der voranstehenden Ansprüche, **dadurch gekennzeichnet, dass** der Wert der Kapazität (C) des Freilaufzweigs (30, 30') größer ist als das Produkt aus dem Maximalwert des Stroms durch die induktive Last (IM1, IM2) mit der zehnfachen Zykluszeit (TZ) dividiert durch die Spannung (U) zwischen Spelsespannungsanschluss (12) und Masseanschluss (14).

## Claims

1. A control circuit for at least one inductive load (M1, M2), comprising a first and a second load branch (20, 50) arranged between a first voltage terminal (12) and a second voltage terminal (14), each comprising an electronic switch (S1, S2) and the inductive load (M1, M2) connected in series, wherein the electronic switch (S1, S2) lies between a first terminal (22, 52) for the inductive load (L) and the first voltage terminal (12), and a second terminal (24, 54) for the inductive load (M1, M2) is connected to the second voltage terminal (14), a freewheeling branch (30, 30') having a capacitance (C) connected to the first voltage terminal (12) and an inductance (L) connected to the second terminal (24, 54) of the inductive load (M1, M2) as a series circuit, as well as a freewheeling diode (D1, D2) arranged between a center tap (36) between the capacitance (C) and the inductance (L) of the freewheeling branch (30, 30') and the first terminal (22, 52) of the respective inductive load (M1, M2), through which a freewheeling current (IM1F, IM2F) of the inductive load (M1, M2) flows when the electronic switch (S1, S2) is open, **characterized in that** the inductive load in the first load branch (20) is a first motor (M1) and the inductive load in the second load branch (50) is a second motor (M2), that the switch-on point (EF1) of one of the electronic switches (S1) and the switch-off point (AF2) of the other of the electronic switches are fixed relative one another, and that the interval of time between the switch-on point (EF1) of the one of the electronic switches (S1, S2) and the switch-on point (EF2) of the other of the electronic switches (S2, S1) varies according to the value of the PWM ratio to be set.

2. The control circuit according to claim 1, **characterized in that** a first terminal (32) of the capacitance (C) of the freewheeling branch (30) is connected to a first terminal (ES1, ES2) of the electronic switch (S1, S2) by means of a line having an inductance which is less than 50 nano-Henry.

3. The control circuit according to any one of the preceding claims, **characterized in that** a second terminal (34) of the capacitance (C) of the freewheeling branch (30) is connected to the respective diode (D1, D2) by a line having an inductance which is less than 50 nano-Henry.

4. The control circuit according to any one of the preceding claims, **characterized in that**

a drive (42, 62) is provided for the electronic switches (51, 52) of the at least two load branches (20, 50) which drives the electronic switches (51, 52) with PWM drive signals (S1A, S2A) having the same period (TZ).

5. The control circuit according to claim 4, **characterized in that**
the PWM drive signals (S1A, S2A) for both load branches (30,50) are phase-locked to one another.

6. The control circuit according to claim 4 or 5, **characterized in that**
the PWM drive signals (S1A, S2A) are phase-shifted to one another.

7. The control circuit according to any one of the preceding claims, **characterized in that**
a drive (42, 62) drives the electronic switches (S1, S2) of the first (20) and the second load branch (50) such that one of said electronic switches (S1) is switched on when the other of said electronic switches (S2) is switched off.

8. The control circuit according to any one of the preceding claims, **characterized in that**
the switching on of each of the electronic switches (S1, S2) in a first operating range only takes place when the respective other electronic switch (S2, S1) is switched off.

9. The control circuit according to claim 8, **characterized in that**
each of the switches (S1, S2) are switched off in said first operating range at an interval of time prior to the switching on of the respective other switch (S2, S1).

10. The control circuit according to claim 9, **characterized in that**
a minimum length of time of 0.5% of the period (TZ) is provided in the first operating range between the switching off of each of the switches (S1, S2) and the switching on of the respective other switch (S2, S1).

11. The control circuit according to any one of claims 8 to 10, **characterized in that**
the switch-on point (EF2) of the one electronic switch (S2) and the switch-off point (AF1) of the other electronic switch (S1) vary within the first operating range.

12. The control circuit according to any one of the preceding claims, **characterized in that**
a switching on of one of the electronic switches (S1, S2) in a second operating range only takes place upon or after the respective other electronic switch (S2, S1) being switched off.

13. The control circuit according to any one of claims 1 to 12, **characterized in that**
a switching on of each of the electronic switches (S1, S2) in the second operating range occurs after the respective other electronic switch (S2, S1) has been switched on and prior to its being switched off.

14. The control circuit according to any one of the preceding claims, **characterized in that**
the product of the value of the inductance (L) and the value of the capacitance (C) in the freewheeling branch (30, 30') is greater than the square of the cycle time (TZ) of the pulse-width-modulated drive signals (S1A, S2A).

15. The control circuit according to any one of the preceding claims, **characterized in that**
the value of the capacitance (C) of the freewheeling branch (30, 30') is greater than the product of the maximum value of the current through the inductive load (IM1, IM2) by ten times the cycle time (TZ) divided by the voltage (U) between the supply voltage terminal (12) and the ground terminal (14).

**Revendications**

1. Circuit de commande pour au moins une charge inductive (M1, M2) comprenant une première et une seconde ramification de charge (20, 50) situées entre une première borne de tension (12) et une seconde borne de tension (14), chaque ramification comprenant un commutateur électronique (S1, S2) et la charge inductive (M1, M2) branchés en série, le commutateur électronique (S1, S2) étant situé entre une première borne (22, 52) de la charge inductive (L) et la première borne de tension (12), et une seconde borne (24, 54) de la charge inductive (M1, M2) étant connectée à la seconde borne de tension (14), une ramification de protection (30, 30') qui, à titre de circuit série, comprend une capacité (C) connectée à la première borne de tension (12) et une inductance (L) connectée à la seconde borne (24, 54) de la charge inductive (M1, M2) ainsi qu'une diode de protection (D1, D2) située entre une prise médiane (36) entre la capacité (C) et l'inductance (L) de la ramification de protection (30, 30') et la première borne (22, 52) de la charge inductive respective (M1, M2), diode via laquelle s'écoule, quand le commutateur électronique (S1, S2) est ouvert, un courant de protection (IM1F, IM2F) de la charge inductive (M1, M2), **caractérisé en ce que** la charge inductive dans la première ramification de charge (20) est un premier moteur (M1), et la charge inductive dans la seconde ramification de charge (50) est un second moteur (M2), **en ce que** l'instant de fermeture (EF1) de l'un des commutateurs électroniques (S1) et l'instant d'ouverture (AF2) de l'autre commutateur électronique sont fixés l'un par rapport à l'autre, et **en ce que** l'intervalle temporel entre l'instant de fermeture (EF1) de l'un des commutateurs électroniques (S1, S2) et l'instant de fermeture (EF2) de l'autre commutateur électronique (S2, S1) varie en correspondance de la valeur de la relation PWM à régler.

2. Circuit de commande selon la revendication 1, **caractérisé en ce qu'**une première borne (32) de la capacité (C) de la ramification de protection (30) est connectée à une première borne (ES1, ES2) du commutateur électronique (S1, S2) au moyen d'une ligne dont l'inductance est inférieure à 50 nano Henry.

3. Circuit de commande selon l'une des revendications précédentes, **caractérisé en ce qu'**une seconde borne (34) de la capacité (C) de la ramification de protection (30) est connectée à la diode respective (D1, D2) avec une ligne dont l'inductance est inférieure à 50 nano Henry.

4. Circuit de commande selon l'une des revendications précédentes, **caractérisé en ce qu'**il est prévu un pilotage (42, 62) pour les commutateurs électroniques (S1, S2) desdites au moins deux ramifications de charge (20, 50), lequel pilote les commutateurs électroniques (S1, S2) avec des signaux de pilotage PWM (S1A, S2A) ayant la même durée de période (TZ).

5. Circuit de commande selon la revendication 4, **caractérisé en ce que** les signaux de pilotage PWM (S1A, S2A) pour les deux ramifications de charge (30, 50) sont en relation de phase fixe l'un par rapport à l'autre.

6. Circuit de commande selon la revendication 4 ou 5, **caractérisé en ce que** les signaux de pilotage PWM (S1A, S2A) sont en décalage de phase l'un par rapport à l'autre.

7. Circuit de commande selon l'une des revendications précédentes, **caractérisé en ce qu'**un pilotage (42, 62) pilote les commutateurs électroniques (S1, S2) de la première (20) et de la seconde (50) ramification de charge de telle façon que l'un des commutateurs électronique (S1) est fermé quand l'autre des commutateurs électroniques (S2) est ouvert.

8. Circuit de commande selon l'une des revendications précédentes, **caractérisé en ce que** dans une première plage de fonctionnement, une fermeture de chacun des commutateurs électroniques (S1, S2) a lieu uniquement quand l'autre commutateur électronique respectif (S2, S1) est ouvert.

9. Circuit de commande selon la revendication 8, **caractérisé en ce que** dans la première plage de fonctionnement l'ouverture de chacun des commutateurs (S1, S2) a lieu avec un intervalle temporel avant une fermeture de l'autre commutateur respectif (S2, S1).

10. Circuit de commande selon la revendication 9, **caractérisé en ce que**, dans la première plage de fonctionnement, il est prévu une durée temporelle minimum de 0,5 % de la durée de période (SZ), entre l'ouverture de chacun des commutateurs (S1, S2) et la fermeture de l'autre commutateur respectif (S2, S1).

11. Circuit de commande selon l'une des revendications 8 à 10, **caractérisé en ce que**, dans la première plage de fonctionnement, l'instant de fermeture (EF2) de l'un des commutateurs électroniques (S2) et l'instant d'ouverture (AF1) de l'autre commutateur électronique (S1) varient.

12. Circuit de commande selon l'une des revendications précédentes, **caractérisé en ce que**, dans une seconde plage de fonctionnement, une fermeture de l'un des commutateurs électroniques (S1, S2) a lieu uniquement lors de l'ouverture ou après l'ouverture de l'autre commutateur électronique (S2, S1).

13. Circuit de commande selon l'une des revendications 1 à 12, **caractérisé en ce que** le, dans la seconde plage de fonctionnement, une fermeture de chacun des commutateurs électroniques (S1, S2) a lieu après la fermeture et avant l'ouverture de l'autre commutateur électronique respectif (S2, S1).

14. Circuit de commande selon l'une des revendications précédentes, **caractérisé en ce que** le produit de la valeur de l'inductance (L) par la valeur de la capacité (C) dans la ramification de protection (30, 30') est supérieur au carré du temps de cycle (TZ) des signaux de pilotage modulés en largeur d'impulsion (S1A, S2A).

**15.** Circuit de commande selon l'une des revendications précédentes, **caractérisé en ce que** la valeur de la capacité (C) de la ramification de protection (30, 30') est supérieure au produit de la valeur maximum du courant traversant la charge inductive (IM1, IM2) par 10 fois le temps de cycle (TZ) divisé par la tension (U) entre la borne de tension d'alimentation (12) et la borne de masse (14).

# FIG.1

# FIG. 2

FIG.3

FIG.4

FIG.5

# FIG.6

PWM = 30 %

# FIG.7

PWM = 50%

# FIG.8

PWM = 80%

a) | 2 | 10 μs | 5.0 V | ... S1A, TE1, TA1, t₁ t₂ t₃ t₄

b) | 3 | 10 μs | 5.0 V | ... S2A, TE2, TA 2, t₁ t₂ t₅

c) | 1 | 10 μs | 4.00 A | ... IM1

d) | 4 | 10 μs | 2.00 A | ... IM2

e) | 1 | 10 μs | 1.00 A | ... IC1+ IC2

f) | 4 | 10 μs | 5.0 A

g) | 4 | 10 μs | 5.0 A

h) | 1 | 10 μs | 50 mV

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19702949 A1

- EP 1028527 A2